# EUROPÄISCHE PATENTSCHRIFT

(11) **EP 2 479 857 B1**
(45) Veröffentlichungstag und Bekanntmachung des Hinweises auf die Patenterteilung: **01.04.2015**
(21) Anmeldenummer: 12152143.9
(22) Anmeldetag: 23.01.2012
(51) Int. Cl.: H02G 3/06, H05K 9/00

(54) **Kabeldurchführung**
Cable feedthrough
Passe-câble

(30) Priorität: 24.01.2011 DE 102011003071
(43) Veröffentlichungstag der Anmeldung: 25.07.2012
(73) Patentinhaber: Lapp Engineering & Co., 6330 Cham (CH)
(72) Erfinder: Drotleff, Rolf, 75932 Deckenpfronn (DE); Müller, Daniel, 71686 Remseck (DE)
(74) Vertreter: Hoeger, Stellrecht & Partner Patentanwälte

(56) Entgegenhaltungen:
- EP-A1- 1 710 880
- DE-A1-102008 019 165
- GB-A- 2 450 519
- US-A1- 2008 073 102
- US-B1- 6 335 488
- US-B1- 7 635 816

## Beschreibung

Die Erfindung betrifft eine Kabeldurchführung umfassend einen Gehäusestutzen, eine an dem Gehäusestutzen vorgesehene Kabelfixierung, einen in dem Gehäusestutzen vorgesehenen Befestigungsabschnitt, mit welchem der Gehäusestutzen an einem Wandabschnitt eines Geräts befestigbar ist, und ein einen Kabelschirm eines durch die Kabeldurchführung hindurchgeführten Kabels kontaktierendes Schirmkontaktelement.

Derartige Kabeldurchführungen sind aus dem Stand der Technik bekannt, wie zum Beispiel die GB 2 450 579.

Bei diesen besteht jedoch das Problem, dass das Schirmkontaktelement keinen sicheren Kontakt mit dem Wandabschnitt des Geräts vermittelt.

Der Erfindung liegt daher die Aufgabe zugrunde, eine Kabeldurchführung der gattungsgemäßen Art derart zu verbessern, dass eine zuverlässige Kontaktierung des Wandabschnitts durch das Schirmkontaktelement möglich ist.

Diese Aufgabe wird bei einer Kabeldurchführung der eingangs beschriebenen Art erfindungsgemäß dadurch gelöst, dass das Schirmkontaktelement mit einem Halteelement an dem Befestigungsabschnitt festlegbar ist und dass das Schirmkontaktelement einerseits den Kabelschirm kontaktiert und andererseits den Wandabschnitt des Geräts mit mindestens einem Gehäusekontaktelement elektrisch kontaktiert, das sich in den Wandabschnitt eingrabend ausgebildet ist.

Der Vorteil der erfindungsgemäßen Lösung ist darin zu sehen, dass durch ein derartiges Gehäusekontaktelement die Möglichkeit besteht, auch bei Oberflächenkorrosion oder Oberflächenbeschichtung des Wandabschnitts eine elektrische Kontaktierung desselben durch das Schirmkontaktelement sicherzustellen.

Hinsichtlich der Anordnung der Gehäusekontaktelemente sind die unterschiedlichsten Möglichkeiten denkbar.

Prinzipiell können die Gehäusekontaktelemente an beliebigen Teilen der Schirmkontaktelemente angeordnet sein.

Eine besonders bevorzugte Lösung sieht vor, dass das mindestens eine Gehäusekontaktelement als am Halteelement vorgesehener Vorsprung ausgebildet ist.

In diesem Fall ist es besonders einfach, den Vorsprung so anzuordnen, dass dieser sich in den Wandabschnitt eingraben kann.

Um das Eingraben in den Wandabschnitt sicherzustellen, ist vorzugsweise vorgesehen, dass der Vorsprung eine dem Wandabschnitt zugewandte scharfkantige Kontur aufweist, mit welcher der Vorsprung in der Lage ist, sich in eine Oberfläche des Wandabschnitts einzugraben.

Eine derartige scharfkantige Kontur ist beispielsweise durch eine Spitze oder eine Schneide realisierbar.

Es wäre aber auch denkbar, mehrere Vorsprünge oder pro Vorsprung auch mehrere scharfkantige Konturen vorzusehen.

Um beim Aufsetzen des Schirmkontaktelements auf den Befestigungsabschnitt die Möglichkeit zu eröffnen, dass sich die scharfe Kontur in die Oberfläche des Gehäusestutzens eingräbt, ist die scharfe Kontur so ausgebildet, dass diese sich bei einer Bewegung des Vorsprungs auf einer Bahn um die Mittelachse des Gehäusesetzens bewegt und sich in die Oberfläche des Wandabschnitts eingräbt.

Eine derartige Bewegung der scharfen Kontur um die Mittelachse des Gehäusestutzens ist in einfacher Weise dadurch realisierbar, dass das Schirmkontaktelement relativ zum Gehäusestutzen oder insbesondere zum Befestigungsabschnitt des Gehäusestutzens verdreht wird.

Eine derartige Verdrehung erfolgt beispielsweise zwangsläufig bei einer Schraubverbindung zwischen dem Schirmkontaktelement und dem Befestigungselement.

Im Falle einer anders ausgebildeten Verbindung zwischen dem Befestigungsabschnitt und dem Schirmkontaktelement ist vorgesehen, dass diese so ausgebildet ist, dass eine Drehung des Schirmkontaktelements relativ zum Befestigungsabschnitt erfolgen kann.

Hinsichtlich der Festlegung des Schirmkontaktelements an dem Befestigungsabschnitt sind die unterschiedlichsten Möglichkeiten denkbar.

Eine denkbare Möglichkeit wäre es, das Schirmkontaktelement kraftschlüssig, das heißt durch Reibung oder Klemmung an dem Befestigungsabschnitt festzulegen.

Eine besonders sichere Festlegung des Schirmkontaktelements am Befestigungsabschnitt erfolgt vorzugsweise dadurch, dass das Schirmkontaktelement formschlüssig mit dem Befestigungsabschnitt verbunden und somit formschlüssig an diesem festlegbar ist.

Eine derartige Festlegbarkeit lässt sich erfindungsgemäß besonders einfach dann realisieren, wenn das Schirmkontaktelement einen den Befestigungsabschnitt des Gehäusestutzens umgreifenden Ringkörper aufweist.

Alternativ oder ergänzend dazu ist es aber auch von Vorteil, wenn das Schirmkontaktelement einen den Befestigungsabschnitt umschließenden Hülsenkörper aufweist.

Sind beispielsweise sowohl ein Ringkörper als auch ein Hülsenkörper vorgesehen, so sieht eine vorteilhafte Lösung vor, dass der Ringkörper und der Hülsenkörper miteinander verbunden, insbesondere aneinander angeformt sind.

Insbesondere lässt sich die Fixierung des Schirmkontaktelements an dem Befestigungsabschnitt dadurch realisieren, dass das Halteelement durch eine Schraubverbindung an dem Befestigungsabschnitt festlegbar ist.

Alternativ dazu ist aber auch denkbar, dass das Halteelement durch Hintergeifen eines Formschusselements an dem Befestigungsabschnitt festlegbar ist.

Dies lässt sich beispielsweise dadurch realisieren, dass das Schirmkontaktelement durch ein Eingreifen zwischen ein Abstützelement des Befestigungsabschnitts und den Wandabschnitt festlegbar ist.

Hinsichtlich des Materials des Gehäusestutzens wurden dabei bislang keine näheren Angaben gemacht.

Prinzipiell könnte der Gehäusestutzen aus einem elektrisch leitfähigem Material sein.

Aus Kostengründen hat es sich jetzt als besonders vorteilhaft erwiesen, wenn der Gehäusestutzen aus einem elektrisch nicht leitenden Material gebildet ist, da damit kostengünstig und in einfacher Weise eine Fixierung des Kabels erfolgen kann, jedoch aufgrund der besonderen Ausbildung des Schirmkontaktelements eine elektrische Leitfähigkeit des Gehäusestutzens nicht nötig ist.

Der Gehäusestutzen könnte dabei aus verschiedensten elektrisch nicht leitenden Materialien sein.

Eine besonders vorteilhafte und kostengünstige Lösung sieht vor, dass der Gehäusestutzen aus Kunststoff ist.

Hinsichtlich der Ausbildung des Schirmkontaktelements wurden bislang keine näheren Angaben gemacht.

So sieht eine besonders günstige Lösung vor, dass das Schirmkontaktelement eine elektrisch leitende Oberfläche aufweist.

Die elektrisch leitende Oberfläche kann auf einem elektrisch nicht leitenden Grundkörpers angeordnet sein.

Eine andere vorteilhafte Lösung sieht vor, dass das Schirmkontaktelement aus einem elektrisch leitenden Material ausgebildet ist, um die Herstellung einer elektrisch leitenden Verbindung zwischen dem Kabelschirm und dem Wandabschnitt realisieren zu können.

Hinsichtlich der Ausbildung des Schirmkontaktelements im Hinblick auf die Kontaktierung des Kabelschirms wurden bislang keine näheren Angaben gemacht.

So sind die unterschiedlichsten Kontaktierungsmöglichkeiten des Kabelschirms denkbar.

Eine vorteilhafte Lösung sieht vor, dass das Schirmkontaktelement ein Borstenelement zur Kontaktierung des Kabelschirms aufweist.

Insbesondere ist bei einem derartigen Borstenelement vorgesehen, dass dieses als Borstenring ausgebildet ist, welcher quer zur Richtung der Mittelachse des Gehäusestutzens verlaufende elektrisch leitende Borsten aufweist.

Die Borsten können dabei beispielsweise in einer Kugelfläche liegend angeordnet sein.

Besonders günstig ist es, wenn die Borsten näherungsweise radial, das heißt in einem Winkelbereich zwischen 80° und 100°, zur Mittelachse verlaufen.

Vorzugsweise ist dabei das Borstenelement mit dem Halteelement des Schirmkontaktelements verbunden, um das Borstenelement entsprechend zu positionieren.

Alternativ oder ergänzend zum Vorsehen eines Borstenelements sieht eine weitere vorteilhafte Lösung vor, dass das Schirmkontaktelement Kabelschirmklemmelemente umfasst, durch welche die Möglichkeit besteht, einzelne Drähte des Kabelschirms an dem Schirmkontaktelement festzuklemmen.

Vorzugsweise sind derartige Kabelschirmklemmelemente so ausgebildet, dass sie eine Klemmung der Drähte des Kabelschirms an den Hülsenkörper des Schirmkontaktelements ermöglichen.

Alternativ oder ergänzend zum Vorsehen von Borstenelementen oder Kabelschirmklemmelementen sieht eine weitere vorteilhafte Lösung der erfindungsgemäßen Kabeldurchführung vor, dass das Schirmkontaktelement Kontaktbügel zur elektrischen Kontaktierung des Kabelschirms aufweist.

Derartige Kontaktbügel können in unterschiedlichster Art und Weise ausgebildet sein.

Eine vorteilhafte Lösung sieht vor, dass die Kontaktbügel mit dem Halteelement mechanisch verbunden sind, insbesondere auch elektrisch leitend verbunden sind.

Ferner ist vorzugsweise vorgesehen, dass die Kontaktbügel radial zur Mittelachse des Gehäusestutzens federnd bewegbare Klemmschenkel für ein elektrisches Kontaktieren des Kabelschirms umfassen.

Besonders günstig ist es dabei, wenn das Schirmkontaktelement den Kabelschirm scherenartig einklemmende Klemmschenkel oder Klemmabschnitte aufweist.

Durch ein derartiges scherenartiges Einklemmen des Kabelschirms durch die Klemmschenkel ist eine zuverlässige elektrische Kontaktierung des Kabelschirms durch das Schirmkontaktelement realisierbar.

Hinsichtlich der Ausbildung der Kontaktbügel wurden im Zusammenhang mit der bisherigen Erläuterung der einzelnen Ausführungsbeispiele keine näheren Angaben gemacht. So sieht eine vorteilhafte Lösung vor, dass das Schirmkontaktelement mindestens zwei Kontaktbügel aufweist, die auf einer ersten Seite des Kabelschirms ein Federelement aufweisen und auf einer zweiten, gegenüberliegenden Seite des Kabelschirms diesen mit einer Kontaktfläche beaufschlagen.

Eine derartige Ausbildung der Kontaktbügel lässt sich insbesondere dann konstruktiv einfach realisieren, wenn die Kontaktbügel übereinanderliegende Durchbrüche zur Durchführung des Kabels mit dem Kabelschirm aufweisen, die federelastisch im Sinne einer Verkleinerung einer Überlappungsfläche der Durchbrüche beaufschlagt sind.

Damit ist in einfacher Weise ein derartiges scherenartiges Einklemmen des Kabelschirms realisierbar.

Insbesondere lässt sich dies konstruktiv einfach dadurch realisieren, dass die Kontaktbügel den Kabelschirm mit einem Randabschnitt der jeweiligen Durchbrüche beaufschlagen.

Ein derartiges Einklemmen des Kabelschirms durch die Kontaktbügel lässt sich konstruktiv einfach dann realisieren, wenn die Kontaktbügel ungefähr parallel zu einer quer zur Mittelachse des Gehäusestutzens verlaufenden Fläche erstreckende Klemmschenkel aufweisen.

Eine alternative Lösung zu der bisherigen Ausbildung der Kontaktbügel sieht vor, dass die den Kabelschirm kontaktierenden Kontaktbügel sich in einen zentralen Durchbruch des Befestigungsabschnitts hineinerstrecken.

Vorzugsweise weisen dabei die Kontaktbügel in Richtung einer Mittelachse des Befestigungselements gewölbte Kontaktschenkel auf, welche den Kontakt mit dem Kabelschirm herstellen.

Dabei sind die Kontaktbügel so ausgebildet, dass sie von dem Halteabschnitt ausgehend die Endfläche des Befestigungsabschnitts umgreifen, um in den zentralen Durchbruch eingreifen zu können.

Dabei können die Kontaktbügel in dem gesamten Gehäusestutzen zu einer Kontaktierung des Kabelschirms führen.

Besonders günstig ist es dabei, wenn die Kontaktbügel mit ihren den Kabelschirm kontaktierenden Schirmkontaktflächen innerhalb des Befestigungselements liegen.

Weitere Merkmale und Vorteile der erfindungsgemäßen Lösung sind Gegenstand der nachfolgenden Beschreibung sowie der zeichnerischen Darstellung einiger Ausführungsbeispiele.

In der Zeichnung zeigen:
- Fig. 1: eine teilweise geschnittene Ansicht eines ersten Ausführungsbeispiels einer erfindungsgemäßen Kabeldurchführung mit Schirmkontaktelement;
- Fig. 2: eine perspektivische Explosionsdarstellung des ersten Ausführungsbeispiels
- Fig. 3: eine Draufsicht auf das erste Ausführungsbeispiel der erfindungsgemäßen Kabeldurchführung mit Blick in Richtung des Pfeils A in Fig. 1;
- Fig. 4: eine perspektivische, teilweise geschnittene Ansicht eines Schirmkontaktelements eines zweiten Ausführungsbeispiels einer erfindungsgemäßen Kabeldurchführung;
- Fig. 5: eine perspektivische, teilweise geschnittene Ansicht eines Schirmkontaktelements eines dritten Ausführungsbeispiels einer erfindungsgemäßen Kabeldurchführung;
- Fig. 6: eine perspektivische, teilweise geschnittene Ansicht eines Schirmkontaktelements eines vierten Ausführungsbeispiels einer erfindungsgemäßen Kabeldurchführung;
- Fig. 7: eine perspektivische Seitenansicht eines Schirmkontaktelements des vierten Ausführungsbeispiels einer erfindungsgemäßen Kabeldurchführung;
- Fig. 8: eine perspektivische, teilweise geschnittene Ansicht eines Schirmkontaktelements eines fünften Ausführungsbeispiels einer erfindungsgemäßen Kabeldurchführung;
- Fig. 9: eine perspektivische, teilweise geschnittene Ansicht eines Schirmkontaktelements eines sechsten Ausführungsbeispiels der erfindungsgemäßen Kabeldurchführung;
- Fig.10: eine perspektivische Ansicht eines Schirmkontaktelements eines siebten Ausführungsbeispiels der erfindungsgemäßen Kabeldurchführung;
- Fig. 11: eine perspektivische, teilweise geschnittene Ansicht eines Schirmkontaktelements eines achten Ausführungsbeispiels der erfindungsgemäßen Kabeldurchführung;
- Fig. 12: eine perspektivische Ansicht eines Schirmkontaktelements eines neunten Ausführungsbeispiels der erfindungsgemäßen Kabeldurchführung;
- Fig. 13: eine umgekehrte perspektivische Ansicht des Schirmkontaktelements gemäß Fig. 12;
- Fig. 14: eine teilweise geschnittene Ansicht eines zehnten Ausführungsbeispiels der erfindungsgemäßen Kabeldurchführung mit Schirmkontaktelement;
- Fig. 15: eine perspektivische Explosionsdarstellung des zehnten Ausführungsbeispiels;
- Fig. 16: eine perspektivische Ansicht des Schirmkontaktelements des zehnten Ausführungsbeispiels;
- Fig. 17: eine perspektivische Ansicht eines Schirmkontaktelements eines elften Ausführungsbeispiels der erfindungsgemäßen Kabeldurchführung;
- Fig. 18: eine perspektivische Ansicht eines zwölften Ausführungsbeispiels einer erfindungsgemäßen Kabeldurchführung;
- Fig. 19: eine perspektivische Ansicht eines dreizehnten Ausführungsbeispiels einer erfindungsgemäßen Kabeldurchführung und
- Fig. 20: eine Explosionsdarstellung eines vierzehnten Ausführungsbeispiels eine erfindungsgemäßen Kabeldurchführung.

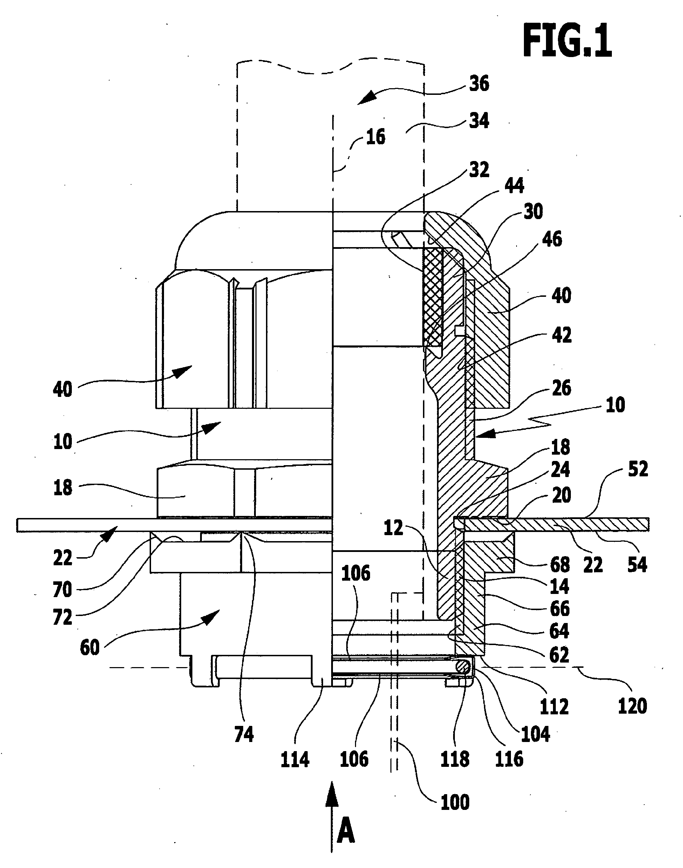

Ein in Fig. 1 dargestelltes erstes Ausführungsbeispiel einer erfindungsgemäßen Kabeldurchführung umfasst einen als Ganzes mit 10 bezeichneten Gehäusestutzen, welcher an einem Ende einen Befestigungsabschnitt 12 aufweist, der ein Außengewinde 14 trägt. An den Befestigungsabschnitt 12 schließt sich ein radial zu einer Mittelachse 16 des Gehäusestutzens 10 über den Befestigungsabschnitt 12 überstehender Druckbund 18 an, welcher, eine dem Befestigungsabschnitt 12 zugewandte Druckfläche 20 trägt, mit welcher der Druckbund 18 an einem Wandabschnitt 22 eines Gerätes anlegbar ist, wenn der Befestigungsabschnitt 12 durch eine Öffnung 24 in dem Wandabschnitt 22 hindurchgeführt ist.

Auf einer dem Befestigungsabschnitt 12 gegenüberliegenden Seite des Druckbunds 18 umfasst der Gehäusestutzen 10 ein weiteres Außengewinde 26 und bildet auf einer dem Druckbund 18 gegenüberliegenden Seite des Außengewindes 26 einen Lamellenkorb 30.

Der Lamellenkorb 30 umschließt seinerseits eine Ringdichtung 32, die an einen Mantel 34 eines durch die Kabeldurchführung hindurchzuführenden Kabels 36 bei Beaufschlagen des Lamellenkorbs 30 in Richtung der Mittelachse 16 anlegbar ist.

Zum Beaufschlagen des Lamellenkorbs 30 ist eine als Ganzes mit 40 bezeichnete Hutmutter vorgesehen, welche mit einem Innengewinde 42 auf das Außengewinde 26 aufschraubbar ist, den Lamellenkorb 30 übergreift und eine konische Druckfläche 44 aufweist, mit welcher der Lamellenkorb 30 beim Aufschrauben der Hutmutter 40 mit dem Innengewinde 42 auf das Außengewinde 26 in Richtung der Mittelachse 16 beaufschlagbar ist, um die Ringdichtung 32 an dem Mantel 34 des Kabels 36 anzulegen.

Ferner umfasst der Gehäusestutzen 10 noch eine Dichtkante 46, gegen welche die Ringdichtung 32 ebenfalls anlegbar ist, um einen dichten Abschluss einerseits gegenüber dem Gehäusestutzen 10 und andererseits gegenüber dem Mantel 34 des Kabels 36 zu erhalten.

Um den Druckbund 18 an eine erste Seite 52 des Wandabschnitts 22 anzulegen und in Anlage zu halten, wird der Befestigungsabschnitt 12 des Gehäusestutzens 10 durch die Öffnung 24 von der ersten Seite 52 in Richtung einer zweiten Seite 54 hindurchgeführt, so dass das Außengewinde 14 des Befestigungsabschnitts 12 über die zweite Seite 54 des Wandabschnitts 22 übersteht.

Zur Festlegung des Befestigungsabschnitts 12 ist an diesem ein Schirmkontaktelement 60 festlegbar, welches ein auf das Außengewinde 14 mit einem Innengewinde 62 aufschraubbares Halteelement 64 umfasst, das seinerseits einen Hülsenkörper 66 und einen an den Hülsenkörper 66 angeformten Ringkörper 68 umfasst, die mit dem Innengewinde 62 versehen sind, wobei bei diesem Ausführungsbeispiel der Ringkörper 68 auf seiner dem Druckbund 18 zugewandten Seite des Hülsenkörpers 66 angeordnet ist und mehrere Gehäusekontaktelemente 70 des Schirmkontaktelements trägt.

Die Gehäusekontaktelemente 70 erstrecken sich dabei ausgehend von einer dem Druckbund 18 und somit auch dem Wandabschnitt 22 zugewandten Stirnseite 72 des Ringkörpers 68 in Richtung des Druckbunds 18 oder des Wandbereichs 22 in Form von Vorsprüngen 74, welche jeweils eine dem Wandbereich 22 zugewandte Spitze 76 aufweisen, die so ausgebildet ist, dass sie in der Lage ist sich in die dem Gehäusekontaktelement 70 zugewandte Seite 53 des Wandabschnitts 22 einzugraben.

Vorzugsweise haben die Vorsprünge 74 bei diesem Ausführungsbeispiel die Form pyramidenähnlicher Körper, welche sich ausgehend von der Stirnseite 72 erheben und zur Spitze 76 hin verlaufende Außenseiten 82 und 84 sowie eine Innenseite 86 aufweisen, die schräg zu der Stirnseite 72 in Richtung der Spitze 76 verläuft.

Ist beispielsweise der Ringkörper 68 mit einem Außenmehrkant 78 versehen, so sind die Vorsprünge 70 derart angeordnet, dass die Spitzen 76 in Verlängerung von Kanten 92 des Mehrkants 78 angeordnet sind und die Außenflächen 82 und 84 Fortsetzungen der beiden sich an der Kante 92 treffenden Mehrkantflächen 94 darstellen.

Beim Aufschrauben des Schirmkontaktelements 60 mit dem Halteelement 64 auf das Außengewinde 14 des Befestigungsabschnitts 12 bewegen sich somit die Vorsprünge 74 auf einer Kreisbahn um die Mittelachse 16 und graben sich bei Berührung der zweiten Seite 54 des Wandabschnitts 22 solange im Verlauf ihrer Bewegung längs der Kreisbahn um die Mittelachse 16 ein, bis der Druckbund 18 des Gehäusestutzens 10 kraftbeaufschlagt an der ersten Seite 52 des Wandabschnitts 22 anliegt, so dass der Wandabschnitt 22 einerseits zwischen dem Druckbund und andererseits zwischen den Vorsprüngen 74 eingespannt ist und somit die Kabeldurchführung fest an dem Wandabschnitt 22 fixiert ist.

Die Vorsprünge 74 haben zum Einen den Effekt, dass sie aufgrund des Eingrabens in die zweite Seite 54 des Wandabschnitts 22 und des dadurch entstehenden Kraft- und/oder Formschlusses eine Drehbarkeit des Ringkörpers 68 und des Hülsenkörpers 66 um die Mittelachse 16 behindern und somit auch dafür sorgen, dass das Schirmkontaktelement 60 im festgedrehten Zustand im Wesentlichen drehfest relativ zum Wandabschnitt 22 fixiert bleibt, so dass die erfindungsgemäße Kabeldurchführung damit dauerhaft an dem Wandabschnitt 22 fixierbar ist. Außerdem haben die Vorsprünge 74 den Vorteil, dass sie aufgrund der Tatsache, dass sie sich in die Seite 54 des Wandabschnitts 22 eingraben, eine gut leitende elektrische Verbindung zwischen den Vorsprüngen 74 und somit den Gehäusekontaktelementen 70 und dem Wandabschnitt 22 herstellen.

Damit ist eine dauerhafte und gut leitende elektrische Verbindung zwischen dem Wandabschnitt 22 und dem Schirmkontaktelement 70 bei montieren der erfindungsgemäßen Kabelverschraubung automatisch realisierbar.

Zur Kontaktierung eines unter dem Mantel 34 des Kabels 36 liegenden Kabelschirms 100 ist bei einem durch die erfindungsgemäße Kabeldurchführung hindurchgeführten Kabel 36 der Mantel 34 in einem über dem Befestigungsabschnitt 12 in Richtung der Mittelachse 16 überstehenden Bereich des Kabels 36 entfernt, so dass der Kabelschirm 100 freiliegt.

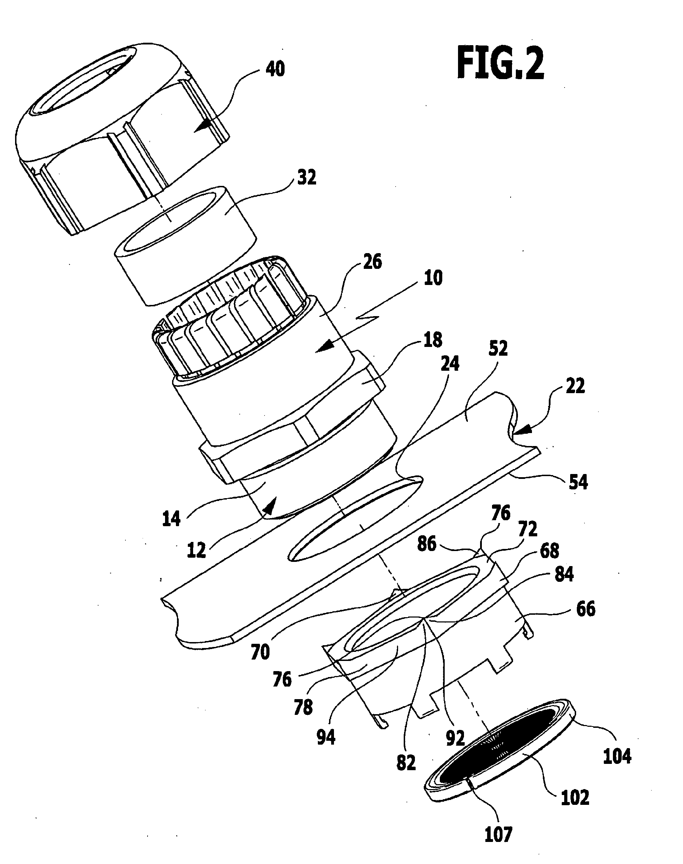

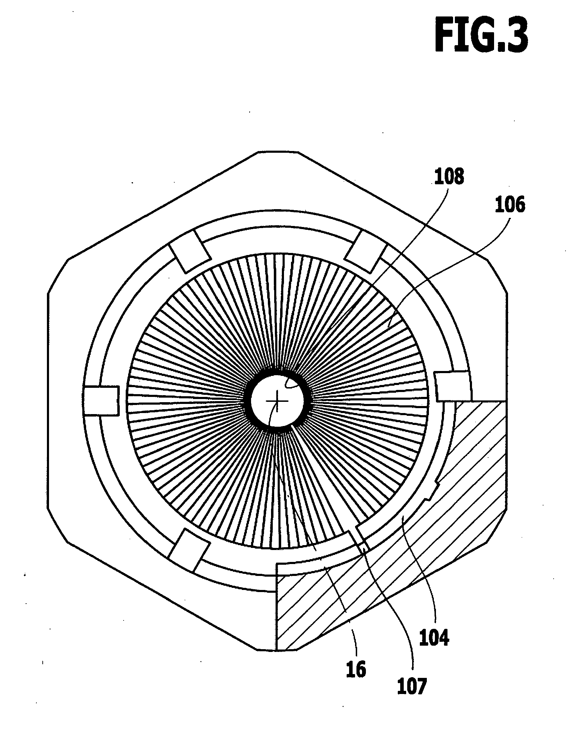

Die Kontaktierung dieses Kabelschirms 100 erfolgt, wie in Figur 1 bis 3 dargestellt, durch ein Borstenelement 102, welches einen ringförmigen Außenkörper 104 aufweist, von welchem ausgehend sich einzelne Borsten 106 in Richtung zur Mittelachse 16 erstrecken und mit ihren inneren Enden 108 in einem Abstand von der Mittelachse 16 stehen, der kleiner ist als ein Radius des auf dem Kabel 36 freigelegten Kabelschirms 100, so dass beim Hindurchschieben des Kabels 36 mit dem freigelegten Kabelschirm 100 durch das Borstenelement 102 eine Kontaktierung des Kabelschirms 100 durch die Vielzahl der einzelnen Borsten 106 erfolgt, die ihrerseits elektrisch leitend mit dem Außenköroper 104 verbunden sind, wobei der Außenkörper 104 auf einer dem Ringkörper 68 gegenüberliegenden Stirnseite 112 des Hülsenkörpers 66 aufliegt und durch Fortsätze 114 des Hülsenkörpers 66 relativ zum Hülsenkörper 66 zentriert und in Anlage an der Stirnseite 112, und zwar kraftbeaufschlagt an dieser gehalten, sind.

Vorzugsweise ist der Außenkörper 104 nicht ringförmig geschlossen, sondern an einer Stelle durch einen Spalt 107 getrennt, so dass durch Verengen des Spalts 107 ein radialelastisches Verhalten des Außenkörpers 104 erzeugbar ist, um den Außenkörper 104 umfangsseitig mit Spannung in eine Aufnahme einsetzen zu können.

Vorzugsweise ist der Außenkörper 104 durch ein im Querschnitt U-förmiges Aufnahmeteil 116 gebildet, welches zur Mittelachse 16 hin offen ist und einen Haltering 118 aufnimmt, wobei die Borsten 106 den Haltering 118 auf seiner dem U-förmigen Aufnahmeteil 116 zugewandten Außenseite umschlingend ausgebildet sind und somit durch Verpressen des Aufnahmeteils 116 mit dem Haltering 118 die dazwischen liegenden Borsten 106 fixiert sind.

Vorzugsweise erstrecken sich die Borsten 106 in geometrischen Flächen oder Ebenen 120, die quer zur Mittelachse 16 und im Abstand von dem Befestigungsabschnitt 12 verlaufen.

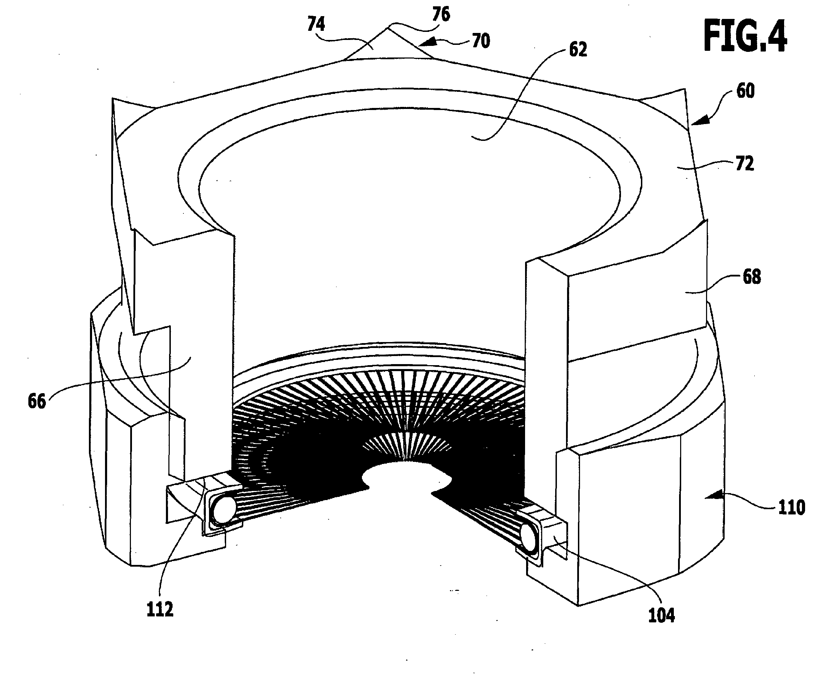

Bei einem zweiten Ausführungsbeispiel, dargestellt in Fig. 4, ist der Außenkörper 104 des Borstenelements 102 dadurch an die Stirnseite 112 des Hülsenkörpers 66 anpressbar, dass von Seiten der Stirnseite 112 auf den Hülsenkörper 66 eine Überwurfmutter 110 aufschraubbar ist, welche den Außenkörper 104 auf einer der Stirnseite 112 gegenüberliegenden Seite übergreift und gegen die Stirnseite 112 anpresst.

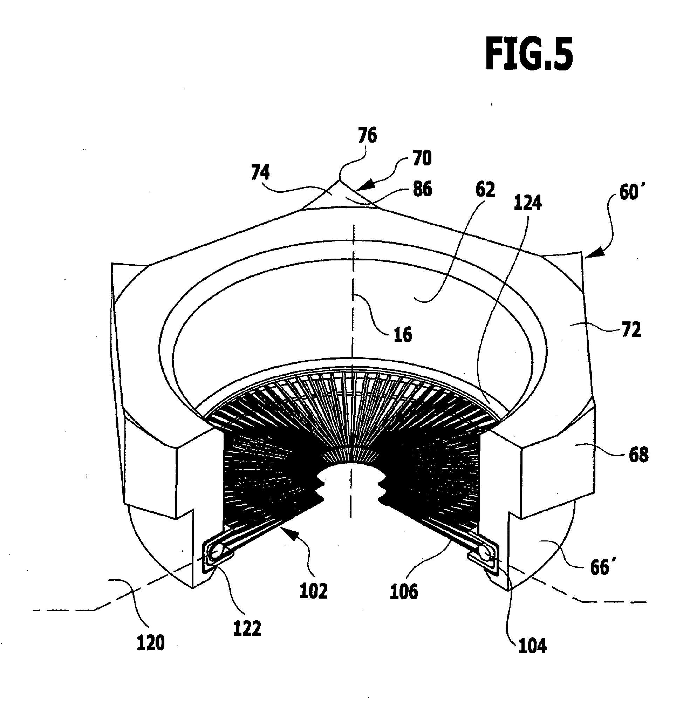

Bei einem dritten Ausführungsbeispiel einer erfindungsgemäßen Kabeldurchführung, dargestellt in Figur 5, ist im Gegensatz zum ersten Ausführungsbeispiel der Hülsenkörper 66' mit einer um die Mittelachse 16 umlaufenden Nut 122 versehen, in welcher der Außenkörper 104 des Borstenelements 102 aufgenommen ist, wobei die Nut 122 sich von einer Innenseite 124 des Hülsenkörpers 66' in diesen hineinerstreckt und so angeordnet ist, dass die Nut 122 in einem über dem Befestigungsabschnitt 12 überstehenden Bereich des Hülsenkörpers 66' angeordnet ist, so dass sich die Borsten 106 in der Ebene 120, die quer zur Mittelachse 16 und im Abstand von dem Befestigungsabschnitt 12 verläuft, erstrecken können.

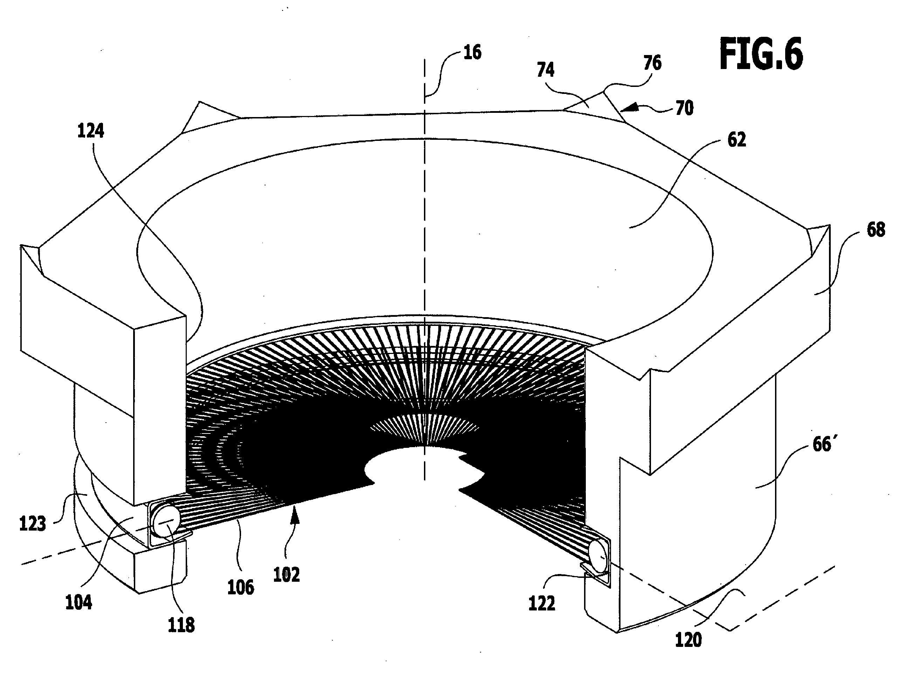

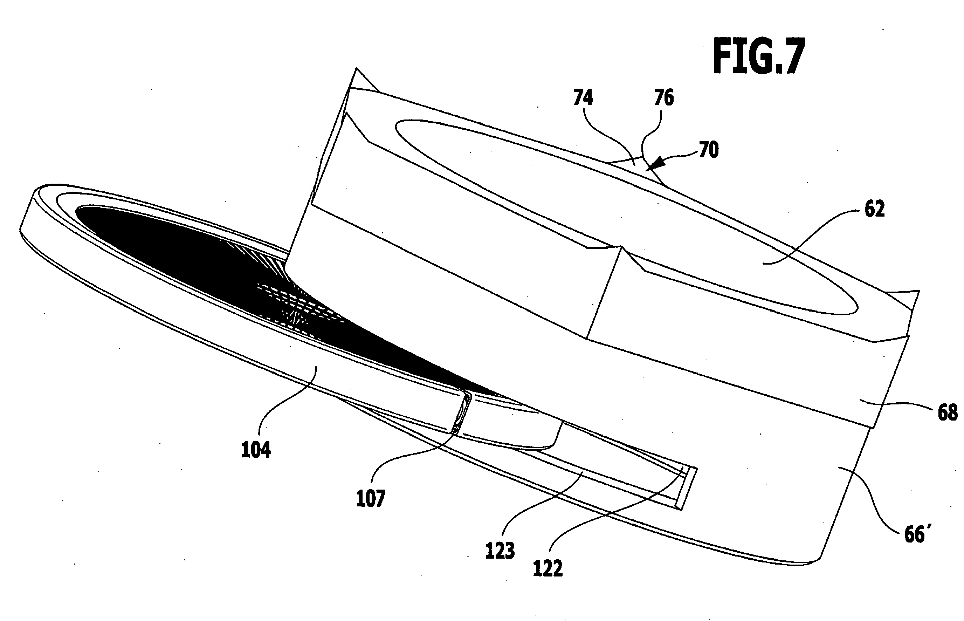

Bei einem vierten Ausführungsbeispiel einer erfindungsgemäßen Kabeldurchführung, dargestellt in Fig. 6 und 7 umfasst der Hülsenkörper 66' eine seitliche Öffnung 123, über welche der Außenkörper 104 des Borstenelements 102 in die Nut 122 einschiebbar ist, wobei sich die Öffnung 123 vorzugsweise über etwas weniger als den halben Umfang der Nut 122 erstreckt, so dass der Außenkörper 104 unter Deformation desselben durch die Öffnung 123 in die Nut 122 einsetzbar ist und dadurch in der Nut 122 fixiert ist.

Dadurch, dass der Außenkörper 104 kein in sich geschlossener Ringkörper ist, sondern zwei einen Spalt 107 begrenzende Enden aufweist, ist der Außenkörper 104 zum Durchschieben durch die Öffnung 123 hinsichtlich seiner Außenabmessung ausreichend federelastisch deformierbar.

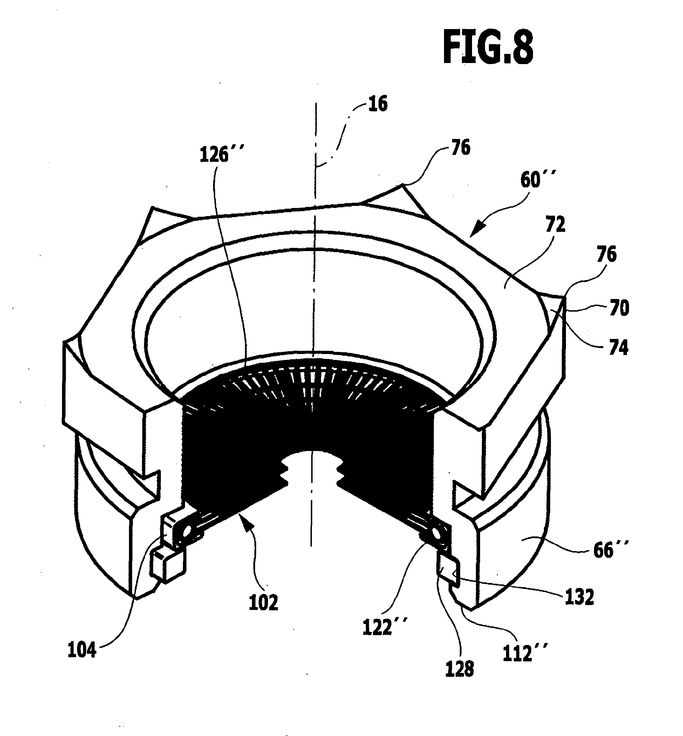

Bei einem fünften Ausführungsbeispiel einer erfindungsgemäßen Kabeldurchführung, dargestellt in Fig. 8 ist der Hülsenkörper 66" mit einer Ausnehmung 122" versehen, die nicht nur in Richtung der Mittelachse 16 offen ist, sondern auch in Richtung der Stirnseite 112" des Hülsenkörpers 66"', so dass das Borstenelement 102 von Seiten der Stirnseite 112"' in die Ausnehmung 122" einsetzbar ist und an einer Flanschfläche 126" der Ausnehmung 122" anlegbar ist.

Zur Festlegung des Außenkörpers 104 des Borstenelements 102 ist noch ein Sicherungsring 128 vorgesehen, welcher in eine entsprechende Sicherungsnut 132 einsetzbar ist, die sich ausgehend von der Ausnehmung 122" radial nach außen in den Hülsenkörper 66" hineinerstreckt und in der Lage ist, den Sicherungsring 128 so aufzunehmen, dass dieser den Außenkörper 104 des Borstenelements 102 in der Ausnehmung 122 zwischen sich und der Flanschfläche 126" festlegt.

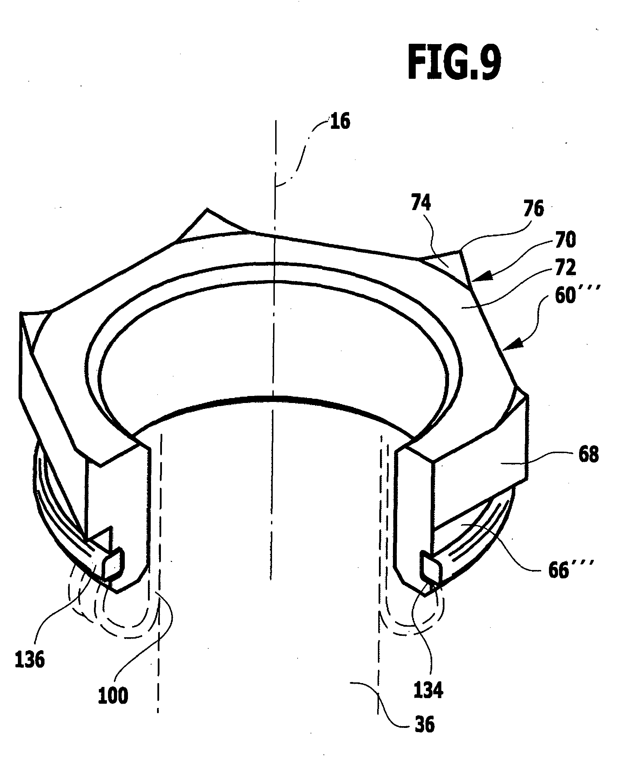

Bei einem sechsten Ausführungsbeispiel einer erfindungsgemäßen Kabeldurchführung, dargestellt in Figur 9, umfasst der Hülsenkörper 66"' auf einer der Mittelachse 16 abgewandten Seite eine außenliegende Nut 134, in welche ein Haltering 136 einsetzbar ist, wobei die Nut 134 und der Haltering 136 so ausgebildet sind, dass dem abgenommenen Haltering 136 der Kabelschirm 100 des Kabels 36 umgeschlagen werden kann und durch den Haltering 136 in die Nut 134 gedrückt werden kann, um eine elektrische Verbindung zwischen dem Kabelschirm 100 und dem Hülsenkörper 66"' herzustellen.

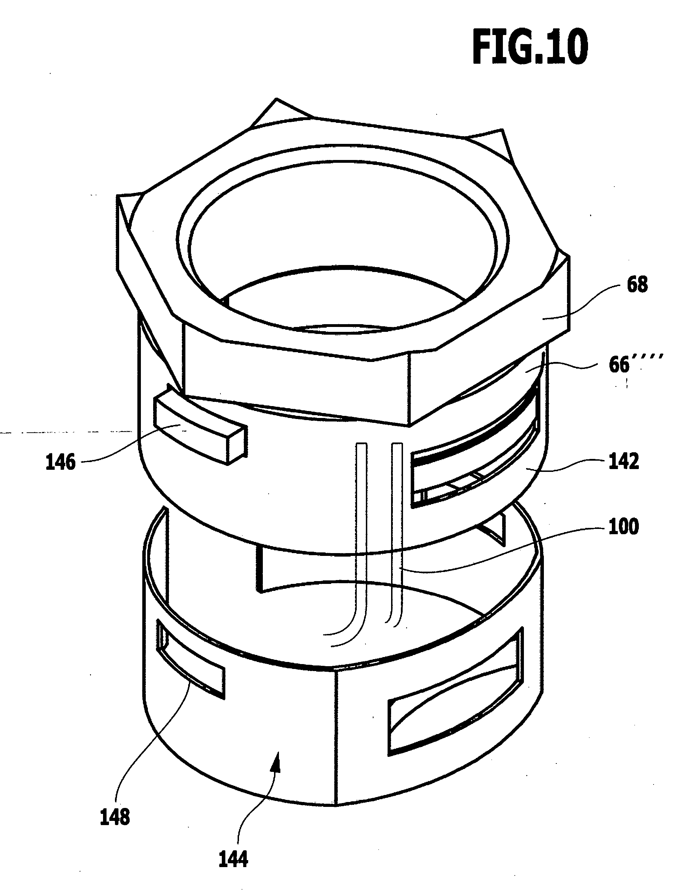

Bei einem siebten Ausführungsbeispiel, dargestellt in Figur 10, ist der Hülsenkörper 66"" so ausgebildet, dass auf eine Außenfläche 142 desselben ein Haltering 144 aufsetzbar ist, der beispielsweise durch ein erstes, an dem Hülsenkörper 64"" vorgesehenes Formschlusselement 146 und ein am Haltering vorgesehenes Formschlusselement 148 fixierbar ist, wobei der Haltering 144 C-förmig ausgebildet und aufgrund der Tatsache, dass dieser nicht geschlossen ist, in einfacher Weise durch elastische Deformation aufweitbar ist, um diesen auf die Außenfläche 142 aufzusetzen und die Formschlusselemente 146 und 148 miteinander in Eingriff zu bringen.

Ferner sind die Drähte des Kabelschirms 100 zwischen dem Haltering 144 und der Außenfläche 142 des Hülsenkörper 66"" einklemmbar.

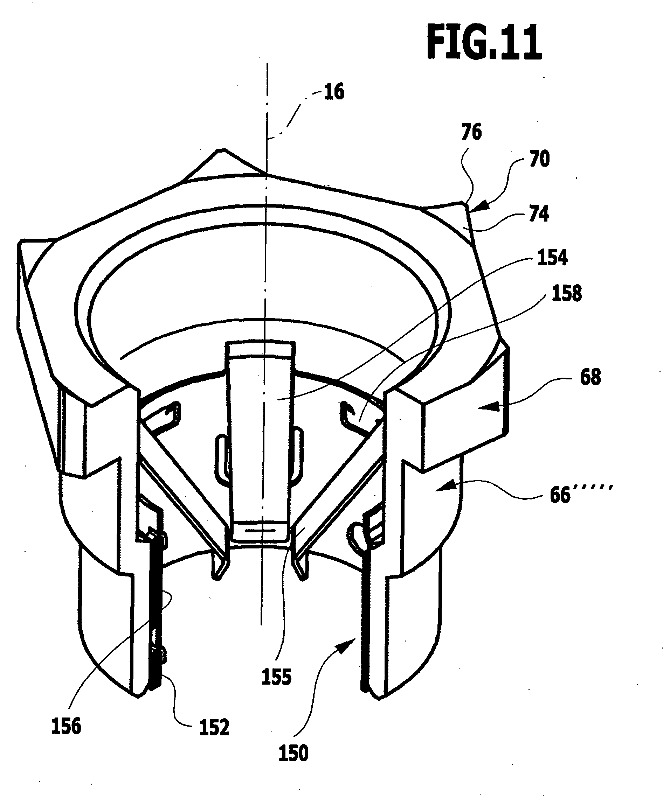

Bei einem achten Ausführungsbeispiel, dargestellt in Figur 11, ist der Hülsenkörper 66""' mit einem Einsatz 150 versehen, welcher eine Klemmhülse 152 aufweist und von der Klemmhülse in Richtung der Mittelachse 16 abstehende Kontaktbügel 154 aufweist, welche in radialer Richtung zur Mittelachse 16 federnd an der Klemmhülse 152 gehalten sind und mit Klemmschenkeln 155 eine Durchgangsöffnung für ein Kabel 36 mit freigelegtem Kabelschirm 100 begrenzen, die durch Einführen des Kabels 36 mit dem freigelegten Kabelschirm 100 aufgeweitet wird.

Die Klemmhülse 152 ist ihrerseits innerhalb des Hülsenkörpers 66""', und zwar an einer Innenseite 156 desselben, entweder kraftschlüssig, vorzugsweise zusätzlich noch formschlüssig, fixiert, wobei Ausbiegungen 158 der Klemmhülse 152 in entsprechende Vertiefungen in dem Hülsenkörper 66""' eingreifen, um die Klemmhülse 152 gegen Bewegungen in Richtung parallel zur Mittelachse 16 festzulegen.

Durch die Kontaktbügel 154 wird dabei erreicht, dass ein Kabelschirm 100 eines durch dieses hindurchgeschobene Kabels 36 elektrisch kontaktiert wird und somit eine elektrisch leitende Verbindung zwischen dem Kabelschirm 100, den Kontaktbügeln 154, der Klemmhülse 152, dem Hülsenkörper 66""' und den Vorsprüngen 74 erfolgt, die sich mit ihren Spitzen 76 in den Wandabschnitt 22 eingraben, um mit diesem ebenfalls eine elektrisch leitende Verbindung einzugehen, so dass eine durchgehend elektrisch leitende Verbindung zwischen dem Kabelschirm 100 und dem Wandabschnitt 22 herstellbar ist.

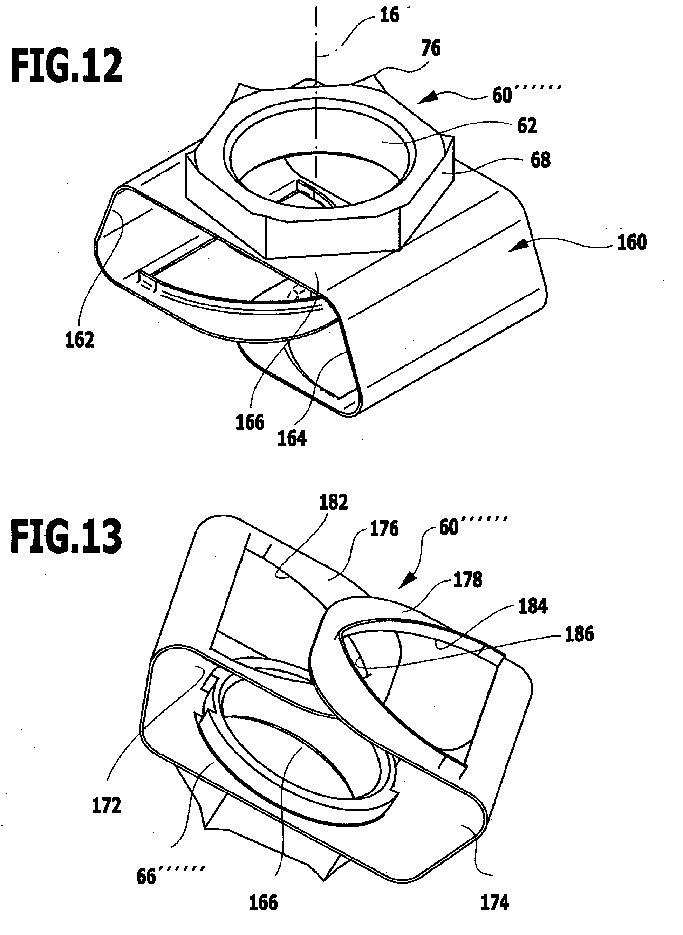

Bei einem neunten Ausführungsbeispiel, dargestellt in Fig. 12 und 13 ist an dem Hülsenkörper 66""" ein Bügelkörper 160 gehalten, welcher zwei Kontaktbügel 162 und 164 aufweist, die ausgehend von einem gemeinsamen Befestigungsabschnitt 166, welcher an dem Hülsenkörper 66""" gehalten ist, sich mit federelastischen Bogenabschnitten 172 und 174 bis zu Klemmabschnitten 176 und 178 erstrecken, die quer zur Mittelachse 16 verlaufen und aneinander anliegen.

Beide Klemmabschnitte 176 und 178 weisen jeweils Durchbrüche 182 und 184 auf, die in einem Überlappungsbereich 186 eine radial querschnittsvariable Durchgangsöffnung für das Kabel 36 mit dem freigelegten Kabelschirm 100 bilden und den Kabelschirm 100 dadurch kontaktieren, dass die Durchgangsöffnung 186 aufgrund der Elastizität der Kontaktbügel 162 und 164 im nicht deformierten Zustand derselben eine Querschnittsfläche aufweist, der kleiner ist als der Querschnittsfläche des Kabels 36 und die durch Deformation der Kontaktbügel 162 und 164 soweit vergrößert werden kann, dass das Kabel 36 mit dem Kabelschirm 100 hindurchgeschoben werden kann, wobei aufgrund der Elastizität der Kontaktbügel 162 und 164 diese die Tendenz haben, die Querschnittsfläche der Durchgangsöffnung 186 soweit zu verkleinern, dass die Klemmabschnitte 176 und 178, insbesondere mit Randbereichen der Durchbrüche 182, 184 scherenartig an dem Kabelschirm 100 des Kabels 36 anliegen und diesen zuverlässigen kontaktieren.

Bei dem zweiten bis neunten Ausführungsbeispiel wurden lediglich die Hülsenkörper und/oder die Schirmkontaktelemente beschrieben und es wurde nicht über den Gehäusestutzen und dessen Ausführung gesagt.

Insoweit als bei dem zweiten bis neunten Ausführungsbeispiel keine weiteren Ausführungen zu Merkmalen des Schirmkontaktelements und des Gehäusestutzens sowie der Fixierung des Kabels in dem Gehäusestutzen mittels des Lammelenkorbs 30 und der Ringdichtung 32 gemacht wurden, wird hinsichtlich des zweiten bis neunten Ausführungsbeispiels vollinhaltlich auf die Ausführungen zum ersten Ausführungsbeispiel Bezug genommen.

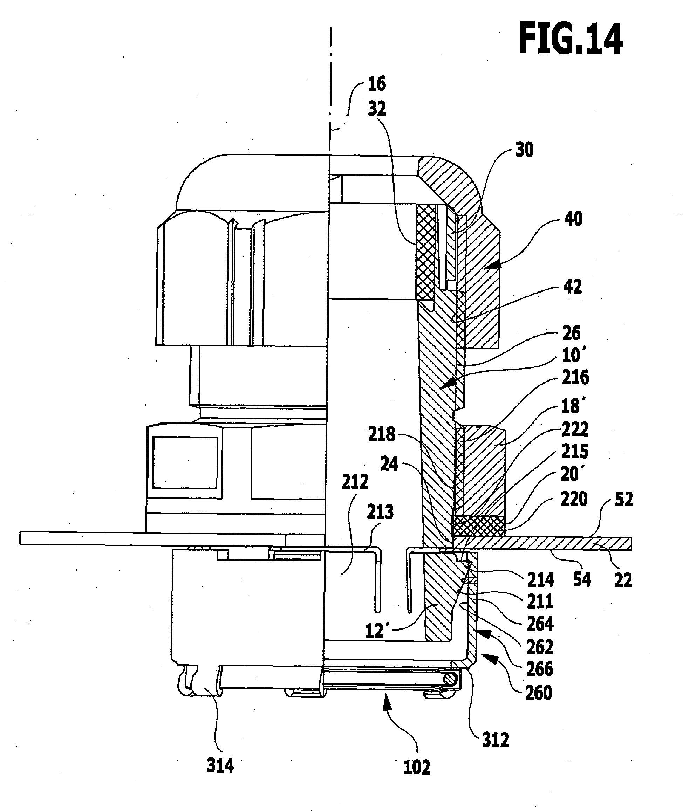

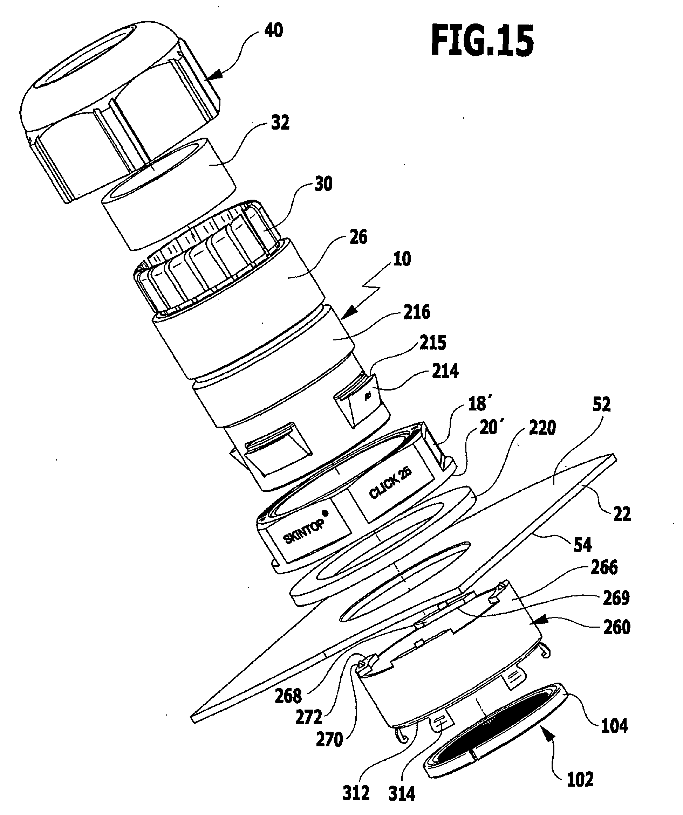

Ein in Figur 14 bis 16 dargestelltes zehntes Ausführungsbeispiel einer erfindungsgemäßen Kabeldurchführung umfasst ebenfalls einen Gehäusestutzen 10', welcher mit einem Befestigungsabschnitt 12' versehen, der allerdings anstelle des Außengewindes 14 mindestens ein an dem Befestigungsabschnitt 12' angeordnetes Abstützelement 214 aufweist, das bei in der Öffnung 24 montierten Gehäusestutzen 10' radial zur Mittelachse 16 über die Öffnung 24 übersteht und mindestens eine radial oder die Öffnung 24 überstehende Abstützfläche 215 aufweist, welche der zweiten Seite 54 des Wandabschnitts 22 zugewandt ist und die Möglichkeit eröffnet, dass sich mit dieser mindestens einen Abstützfläche 215 der Befestigungsabschnitt 12' des Gehäusestutzens 10' direkt oder indirekt an dem Wandabschnitt 22 abstützen kann.

Die Abstützfläche 215 ist dabei relativ zum Befestigungsabschnitt 12' in Richtung der Mittelachse 16 feststehend angeordnet, so dass zur Anpassung an unterschiedliche Wanddicken des Wandabschnitts 22 oder auch zum kraftschlüssigen Einspannen des Wandabschnitts 22 zwischen der Abstützfläche 215 und dem Druckbund 18' die Notwendigkeit besteht, den Druckbund 18' in Richtung der Mittelachse 16 verstellbar an dem Gehäusestutzen 10' anzuordnen.

Aus diesem Grund ist der Gehäusestutzen 10' mit einem Außengewinde 216 versehen, welches mit einem Innengewinde 218 des Druckbund 18' in Eingriff steht, so dass durch Drehen des Druckbunds 18' dessen Position in Richtung der Mittelachse 16 verstellbar ist.

Vorzugsweise stellen das Außengewinde 216 und das Innengewinde 218 zu den Gewinden 26 und 42, mit welchen die Hutmutter 40 aufschraubbar ist gegenläufige Gewinde dar, so dass ein beim Aufschrauben der Hutmutter 40 auf den Gehäusestutzen 10' ausgeübtes Drehmoment dazu führt, dass sich der Druckbund 18' und das Abstützelement 214 mit der Abstützfläche 215 aufeinander zubewegen, um den Wandabschnitt 22 zwischen diesen einzuspannen.

Vorzugsweise ist zwischen dem Druckbund 18' und der ersten Seite 52 des Wandabschnitts 22 noch ein Dichtelement 220 angeordnet, welches einerseits an einer gewindefreien Außenfläche 222 des Gehäusestutzens 10' anliegt und sich zwischen der Druckfläche 20 und der ersten Seite 52 des Wandabschnitts 22 erstreckt.

Dabei ist das Dichtelement 220 so ausgebildet, dass es bei Kompression zwischen der Druckfläche 20' und der ersten Seite 52 des Wandabschnitts 22 auch in radialer Richtung expandiert und somit kraftbeaufschlagt an der gewindefreien Außenfläche 222 des Gehäusestutzens 10' anliegt, um eine Abdichtung zwischen der ersten Seite 52 des Wandabschnitts 22 und dem Gehäusestutzen 10' zu gewährleisten.

Im Übrigen ist der Gehäusestutzen 10' hinsichtlich der Ausbildung es Lammelenkorbs 30 und der Ringdichtung 32 zur Fixierung eines Kabels 36 sowie der Ausbildung der Hutmutter 40 identisch aufgebaut wie beim ersten Ausführungsbeispiel, so dass diesbezüglich vollinhaltlich auf die Ausführungen der voranstehenden Ausführungsbeispielen Bezug genommen werden kann. Bei dem zehnten Ausführungsbeispiel sind die Abstützelemente 214 tragende Wandbereiche 212 des Befestigungsabschnitts 12' durch eine U-förmige Trennfuge 213 derart freigestellt, dass die Wandbereiche 212 mitsamt den Abstützelementen 214 sich von einer Abstützstellung soweit federnd nach innen bewegen können, dass die Abstützfläche 215 innerhalb einer maximalen radialen Ausdehnung des Befestigungsabschnitts 12' liegt, welche geringer ist, als die Öffnung 24 in dem Wandabschnitt 22, so dass der Befestigungsabschnitt 12 von der ersten Seite 52 des Wandabschnitts 22 ausgehend durch die Öffnung 24 hindurchschiebbar ist und somit das mindestens eine Abstützelement 214 schließlich über die zweite Seite 54 des Wandabschnitts 22 übersteht.

Vorzugsweise sind die Abstützelemente 214 hierzu noch mit Einschubschrägen 211 versehen.

Bei dem zehnten Ausführungsbeispiel umfasst das Schirmkontaktelement 260 als Halteelement 264 den Hülsenkörper 266, dessen Innenwand 262 einen derartigen Durchmesser aufweist, dass dieser mindestens der radialen Ausdehnung der Abstützelemente 214 in der Abstützstellung entspricht, so dass der Hülsenkörper 266 in der Lage ist, die Abstützelemente 214 radial außenliegend zu umgreifen.

Ferner sind an den Hülsenkörper 266 Flanschsegmente 268 angeformt, die über die Innenwand 262 radial zur Mittelachse 16 nach Innen überstehen und in der Lage sind, die Abstützfläche 215 zu übergreifen, so dass die Flanschsegmente 268 mit einer der Abstützfläche 215 zugewandten Auflagefläche 269 an der mindestens einen Abstützfläche 215 anliegen und mit einer der zweiten Seite 54 des Wandabschnitts 22 zugewandten Stirnseite 272 an die zweite Seite 54 des Wandabschnitts 22 anlegbar sind.

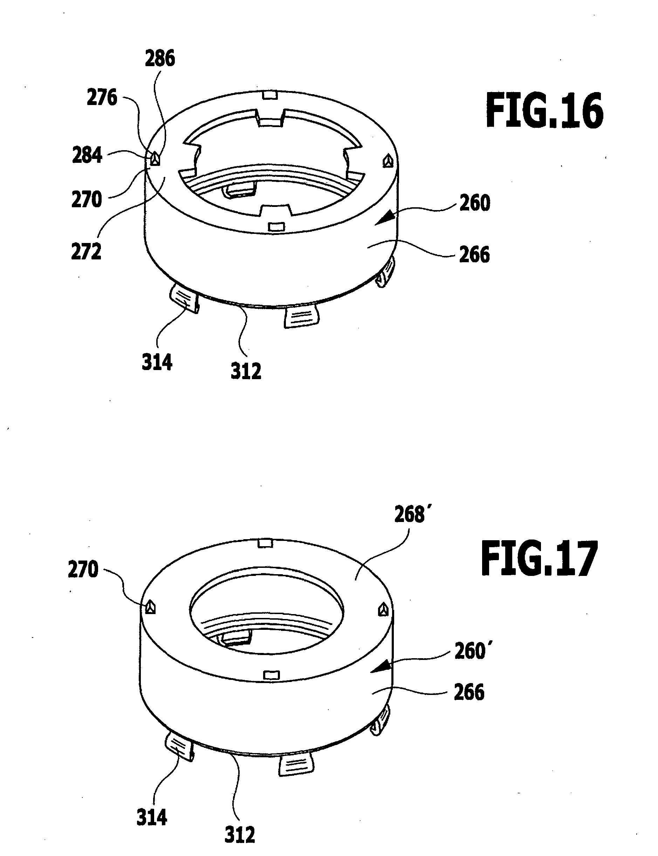

Bei dem Schirmkontaktelement 260 sind auf den Stirnseiten 272 ebenfalls Gehäusekontaktelemente 270 vorgesehen, die sich als Vorsprünge 274 über die Stirnseite 272 erheben und, wie insbesondere in Fig. 16 dargestellt, dachförmig aufeinanderzu verlaufende Seitenflächen 284 und 286 aufweisen, die auf einer der Stirnseite 272 abgewandten Seite eine Schneidkante 276 bilden, welche parallel zu einer Umlaufrichtung um die Mittelachse 16 verläuft, so dass ein Drehen des Schirmkontaktelements 260 dazu führt, dass sich die Schneidkanten 276 in die zweite Seite 54 des Wandabschnitts 22 eingraben, in gleicher Weise wie dies bei den Spitzen 76 der Ausführungsbeispiele eins bis sieben der Fall ist.

Zur Kontaktierung des Kabelschirms 100 ist in gleicher Weise wie beim ersten bis dritten Ausführungsbeispiel vorgesehen, ein Borstenelement 102 vorgesehen, das in gleicher Weise wir beim ersten bis dritten Ausführungsbeispiel aufgebaut ist und über den Fortsätzen 114 des ersten Ausführungsbeispiels in entsprechende Fortsätze 314 des Hülsenkörpers 266 an diesem fixiert ist, wobei das Borstenelement in gleicher Weise wie beim ersten Ausführungsbeispiel beschrieben auf der Stirnseite 312 des Hülsenkörpers 266 aufliegt.

Ist der Gehäusestutzen 10' des zehnten Ausführungsbeispiels mit dem Befestigungsabschnitt 12' soweit durch die Öffnung 24 des Wandabschnitts 22 hindurchgeschoben, dass die Abstützelemente 214 über die zweite Seite 54 des Wandabschnitts 22 überstehen, so ist damit bereits eine Vorfixierung des Gehäusestutzens 10' an dem Wandabschnitt 22 erfolgt.

Das Aufsetzen des Schirmkontaktelements 260 erfolgt nun so, dass der Hülsenkörper 266 mit den Flanschsegmenten 268 über dem Befestigungsabschnitt 12' so weit geschoben wird, bis die Flanschsegmente 268 mit den von diesen getragenen Gehäusekontaktelementen 270, insbesondere deren Schneidkanten 276, an der zweiten Seite 54 anliegen, wobei die Flanschsegmente 268 zwischen den einzelnen Abstützelementen 214 stehen und durch Drehen des Schirmkontaktelements 260 ein Bewegen der Flanschsegmente 268 zwischen die Abstützelemente 214 und die zweite Seite des Wandabschnitts 22 erfolgt, so dass die Abstützelemente 214 mit ihren Abstützflächen 215 an der Auflagefläche 26 der Flanschsegmente 268 anliegen und somit durch die Abstützelemente 214 die Flanschsegmente 268 in Richtung der zweiten Seite 54 des Wandabschnitts 22 beaufschlagt werden, um die Gehäusekontaktelemente 270 an oder in die zweite Seite 54 des Wandabschnitts 22 zu drücken.

Wenn ein Drehen des Druckbundes 18' relativ zum Gehäusestutzen 10' in der Weise erfolgt, dass die Druckfläche 20' in Richtung der ersten Seite 52 des Wandabschnitts 22 bewegt wird, um über das Dichtelement 220 die erste Seite 52 des Wandabschnitts 22 so zu beaufschlagen, wird der Befestigungsabschnitt 12' mit den Abstützelementen 214 in Richtung der zweiten Seite 54 des Wandabschnitts 22 bewegt, um schließlich indirekt den zweiten Wandabschnitt 22 zwischen den Abstützelementen 214 und dem Druckbund 18' einzuspannen, wobei dadurch ein Eindrücken der Gehäusekontaktelemente 270 in die zweite Seite 54 des Wandabschnitts 22 erfolgt und ein Quetschen des Dichtelements 22, so dass dieses in der beschriebenen Art und Weise einen dichten Abschluss zwischen der ersten Seite 52 des Wandabschnitts 22 und dem Gehäusestutzen 10' im Bereich der Außenfläche 222 bewirkt.

Bei einem elften Ausführungsbeispiel, dargestellt in Figur 17 ist das Schirmkontaktelement 260' so ausgebildet, dass dieses nicht einzelne Flanschsegmente 268 aufweist, sondern einen durchlaufenden Ringflansch 268', auf welchem die in gleicher Weise wie beim achten Ausführungsbeispiel ausgebildeten Gehäusekontaktelemente 270 angeordnet sind.

In diesem Fall erfolgt ein Aufsetzen des Schirmkontaktelements 260' auf den Befestigungsabschnitt 12' so, dass durch den Ringflansch 268 die Abstützelemente 214 ebenfalls federnd, in gleicher Weise wie beim Hindurchschieben derselben durch die Öffnung 24, radial zur Mittelachse 16 nach innen gedrückt werden und bis der Flanschring 268' zwischen den Abstützelementen 214 und der zweiten Seite 54 des Wandabschnitts 22 liegt.

Um dabei zu erreichen, dass sich die Gehäusekontaktelemente 270 mit ihren Schneidkanten 276 mit Sicherheit in die Seite 54 des Wandabschnitts 22 eingraben, kann noch ein beliebiges Drehen des Schirmkontaktelements 260' erfolgen, solange bis ein ausreichendes Eingraben in die zweite Seite 54 des Wandabschnitts 54 erreicht ist.

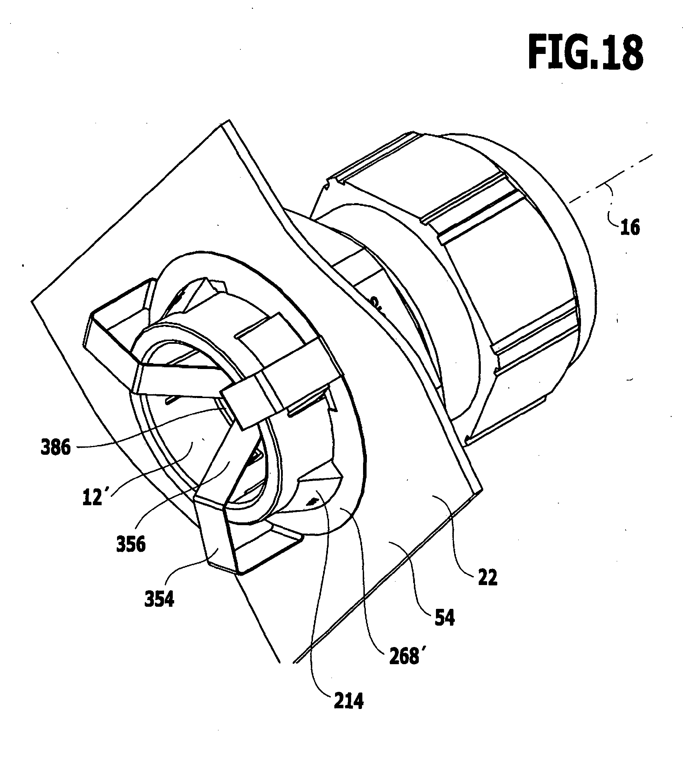

Bei einem zwölften Ausführungsbeispiel dargestellt in Fig. 18 sind diejenigen Teile, die mit denen des achten und neunten Ausführungsbeispiels identisch sind, mit denselben Bezugszeichen versehen, so dass vollinhaltlich auf die Ausführungen zu diesen Ausführungsbeispielen und deren Bezugnahmen ebenfalls Bezug genommen werden kann.

Bei dem zwölften Ausführungsbeispiel ist im Gegensatz zum elften Ausführungsbeispiel kein Hülsenkörper 266 vorgesehen, sondern lediglich der umlaufende Ringflansch 268', welcher die Gehäusekontaktelemente 70 trägt.

Von dem Ringflansch 268' ausgehend erstrecken sich Kontaktbügel 354 mit Klemmschenkeln 356 in ein Inneres des Befestigungsabschnitts 12 hinein um einen in diesem liegenden Kabelschirm 100 zu kontaktieren, wobei die Kontaktbügel 354 in radialer Richtung zur Mittelachse 16 federnd ausgebildet sind und dadurch die Klemmschenkel 356 eine radial querschnittsvariable Durchgangsöffnung für das Kabel 36 mit freiliegendem Kabelschirm 100 bilden, die beim Einschieben des Kabels 36 mit freiliegendem Kabelschirm 100 aufgeweitet wird, so dass durch diese Deformation der Kontaktbügel 354 die Klemmschenkel 356 mit ausreichend großer Kraft den Kabelschirm 100 beaufschlagen und eine sichere Kontaktierung desselben ermöglichen.

Die Fixierung des Flanschrings 268' mittels den Abstützelementen 214 erfolgt ebenfalls dadurch, dass der Befestigungsabschnitt 12 durch den Flanschring 268' hindurch gedrückt wird, wobei die Abstützelemente 214 im Zusammenhang mit der im achten und neunten Ausführungsbeispiel beschriebenen Art und Weise radial federnd nach innen ausweichen, um schließlich den Flanschring 268' auf einer dem Wandabschnitt 22 gegenüberliegenden Seite mit den Abstützflächen 215 zu hintergreifen.

Im Übrigen kann hinsichtlich der Beschreibung der weiteren Merkmale des zehnten Ausführungsbeispiels vollinhaltlich auf das zehnte und elfte Ausführungsbeispiel Bezug genommen werden.

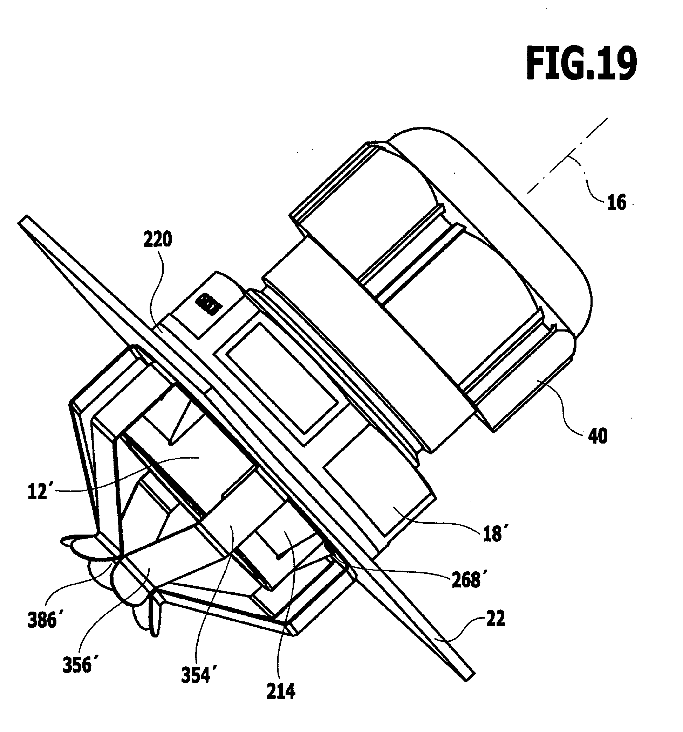

Auch bei dem dreizehnten Ausführungsbeispiel, dargestellt in Fig. 19, ist in gleicher Weise wie beim zehnten Ausführungsbeispiel lediglich ein Flanschring 268' vorhanden, welchen die Abstützelemente 214 auf einer dem Wandabschnitt 22 gegenüberliegenden Seite hintergreifen.

In gleicher Weise wie beim zehnten Ausführungsbeispiel erstrecken sich von dem Flanschring 268' ausgehend Kontaktbügel 354', welche radial zur Mittelachse 16 federnd ausgebildet sind und mit ihren Klemmschenkeln 356' im unbeaufschlagten Zustand eine radial querschnittsvariable Durchgangsöffnung für das Kabel 36 mit freiliegendem Kabelschirm 100 bilden, welche im Abstand von dem Befestigungsabschnitt 12 und zwar auf einer dem Druckbund 18' abgewandten Seite desselben liegt.

Wie beim zwölften Ausführungsbeispiel führt ein Einführen eines Kabels 36 mit freigelegtem Kabelschirm 100 zu einer Aufweitung der Durchgangsöffnung und somit zu einer sicheren Kontaktierung.

Im Übrigen ist dieses Ausführungsbeispiel in gleicher Weise ausgebildet, wie das zehnte, elfte und zwölfte Ausführungsbeispiel, so dass hinsichtlich der Beschreibung der einzelnen Elemente vollinhaltlich auf diese Ausführungsbeispiele Bezug genommen werden kann.

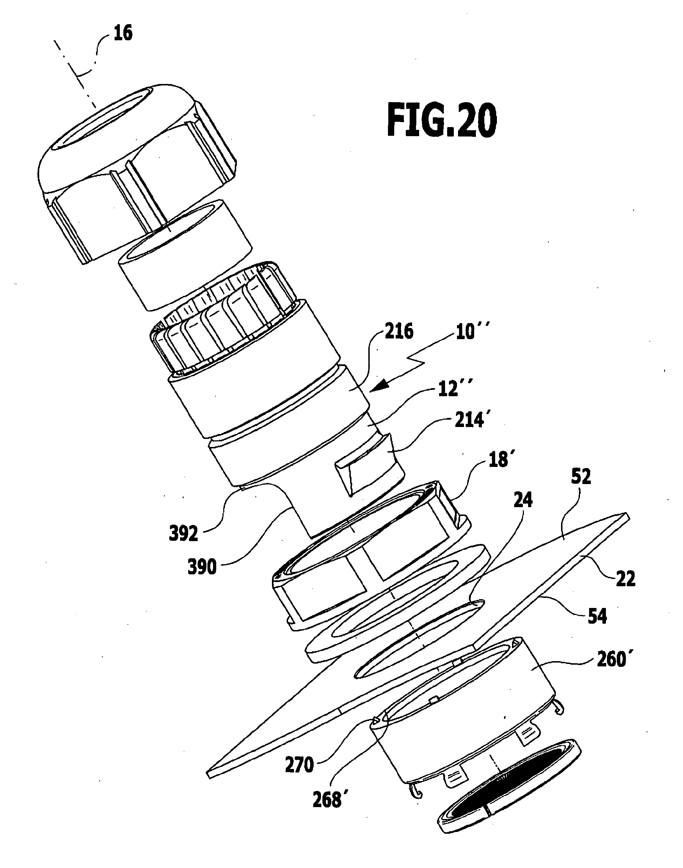

Bei einem vierzehnten Ausführungsbeispiel, dargestellt in Fig. 20 sind im Gegensatz zum achten bis elften Ausführungsbeispiel keine radial zur Mittelachse 16 federnd ausgebildeten Abstützelemente 214 vorgesehen, sondern starr am Befestigungsabschnitt 12" angeordnete Abstützelemente 214", die allerdings nur auf einer Seite des Befestigungsabschnitts 12" radial überstehen, während auf einer gegenüberliegenden Seite der Befestigungsabschnitt 12" eine einen Durchmesser derselben reduzierende halbseitige Ausnehmung 390 aufweist, welche es ermöglicht, den Befestigungsabschnitt 12" so durch die Öffnung 24 des Wandabschnitts 22 trotz überstehendem Abstützelement 214' hindurchzuführen und den Befestigungsabschnitt 12" dadurch in der Öffnung 24 zu fixieren, dass dieser durch eine Zentrierfläche 392 des Befestigungsabschnitts 12 in der Öffnung 24 zentriert wird, wenn das Abstützelement 214' auf der zweiten Seite 54 des Wandabschnitts 22 radial über die Öffnung 24 übersteht, um dem Befestigungsabschnitt 12" in der Öffnung 24 zu fixieren.

Ferner ist das Schirmkontaktelement 260 beispielsweise ausgebildet wie im Zusammenhang mit dem neunten Ausführungsbeispiel beschrieben, wobei in diesem Fall das Abstützelement 214' einseitig den Flanschring 268' hintergreift, um auch das Schirmkontaktelement an dem Wandabschnitt 22 in Anlage an der zweiten Seite 54 des Wandabschnitts 22 zu halten, während der Druckbund 18'gedreht wird, um den Gehäusestutzen 10" mit dem Befestigungsabschnitt 12".

Im Übrigen ist dieses Ausführungsbeispiel in gleicher Weise ausgebildet, wie die Ausführungsbeispiele zehn bis zwölf, so dass auf diese vollinhaltlich Bezug genommen werden kann.

## Patentansprüche

1. Kabeldurchführung umfassend einen Gehäusestutzen (10), eine an den Gehäusestutzen vorgesehene Kabelfixierung (30, 32, 40), einen in dem Gehäusestutzen (10) vorgesehenen Befestigungsabschnitt (12), mit welchem der Gehäusestutzen (10) an einem Wandabschnitt (22) eines Geräts befestigbar ist, und ein einen Kabelschirm (100) eines durch die Kabeldurchführung hindurchgeführten Kabels (36) kontaktierendes Schirmkontaktelement (60, 260),
**dadurch gekennzeichnet,** dass das Schirmkontaktelement (60, 260) mit einem Halteelement (64, 264) an dem Befestigungsabschnitt (12) festlegbar ist und dass das Schirmkontaktelement (60, 260) einerseits den Kabelschirm (100) kontaktiert und andererseits den Wandabschnitt (22) des Geräts mit mindestens einem Gehäusekontaktelement (70, 270) elektrisch kontaktiert, das sich in den Wandabschnitt (22) eingrabend ausgebildet ist.

2. Kabeldurchführung nach Anspruch 1, **dadurch gekennzeichnet, dass** das mindestens eine Gehäusekontaktelement (70, 270) als am Halteelement (64, 264) vorgesehener Vorsprung (74, 274) ausgebildet ist.

3. Kabeldurchführung nach Anspruch 1 oder 2, **dadurch gekennzeichnet, dass** der Vorsprung (74, 274) eine dem Wandabschnitt (22) zugewandte scharfkantige Kontur (76, 276) aufweist, mit welcher der Vorsprung (74, 274) in der Lage ist, sich in eine Oberfläche des Wandabschnitts (22) einzugraben.

4. Kabeldurchführung nach einem der voranstehenden Ansprüche,
**dadurch gekennzeichnet, dass** das Schirmkontaktelement (60, 260) an dem Befestigungsabschnitt (12) formschlüssig festlegbar ist.

5. Kabeldurchführung nach dem Oberbegriff des Anspruchs 1 oder nach einem der voranstehenden Ansprüche, **dadurch gekennzeichnet, dass** das Schirmkontaktelement (60, 260) einen den Befestigungsabschnitt (12) des Gehäusestutzens (10) umgreifenden Ringkörper (68, 268) aufweist.

6. Kabeldurchführung nach dem Oberbegriff des Anspruchs 1 oder nach einem der voranstehenden Ansprüche, **dadurch gekennzeichnet, dass** das Schirmkontaktelement (60, 260) einen den Befestigungsabschnitt (12) umschließenden Hülsenkörper (66, 266) aufweist.

7. Kabeldurchführung nach einem der voranstehenden Ansprüche,
**dadurch gekennzeichnet, dass** das Halteelement (64, 264) durch eine Schraubverbindung an dem Befestigungsabschnitt (12) festlegbar ist.

8. Kabeldurchführung nach einem der Ansprüche 1 bis 7, **dadurch gekennzeichnet, dass** das Haltelement (64, 264) durch hintergreifen eines Formschlusselements (214) an dem Befestigungsabschnitt (12) festlegbar ist.

9. Kabeldurchführung nach einem der voranstehenden Ansprüche,
**dadurch gekennzeichnet, dass** das Schirmkontaktelement (60, 260) durch ein Eingreifen zwischen ein Abstützelement (214) des Befestigungsabschnitts (12) und den Wandabschnitt (22) festlegbar ist.

10. Kabeldurchführung nach einem der voranstehenden Ansprüche,
**dadurch gekennzeichnet, dass** der Gehäusestutzen (10) aus einem elektrisch nicht leitenden Material ausgebildet ist.

11. Kabeldurchführung nach einem der voranstehenden Ansprüche,
**dadurch gekennzeichnet, dass** das Schirmkontaktelement (60, 260) ein Borstenelement (102) zur Kontaktierung des Kabelschirms (100) aufweist und dass insbesondere das Borstenelement (102) als Borstenring ausgebildet ist, welcher quer in Richtung der Mittelachse (16), des Gehäusestutzens (10) verlaufende elektrisch leitende Borsten (106) aufweist.

12. Kabeldurchführung nach Anspruch 11, **dadurch gekennzeichnet, dass** das Borstenelement (102) mit dem Halteelement (64, 264) des Schirmkontaktelements (60, 260) verbunden ist.

13. Kabeldurchführung nach einem der voranstehenden Ansprüche,
**dadurch gekennzeichnet, dass** das Schirmkontaktelement (60"', 60"") Kabelschirmkontaktelemente (136, 144) umfasst.

14. Kabeldurchführung nach einem der voranstehenden Ansprüche,
**dadurch gekennzeichnet, dass** das Schirmkontaktelement (60, 260) Kontaktbügel (154, 162, 164, 354) zur elektrischen Kontaktierung des Kabelschirms (100) aufweist.

15. Kabeldurchführung nach Anspruch 14, **dadurch gekennzeichnet, dass** die Kontaktbügel (154, 162, 164, 354) mit dem Halteelement (64, 264) verbunden sind und dass insbesondere die Kontaktbügel (154, 162, 164, 354) radial zu der Mittelachse (16) des Gehäusestutzens (10) federnd bewegbare Klemmschenkel für ein elektrisches Kontaktieren des Kabelschirms (100) umfassen.

## Claims

1. Cable feedthrough comprising a housing connection piece (10), a cable fixing device (30, 32, 40) provided on the housing connection piece, a fastening section (12) provided on the housing connection piece (10) for securing the housing connection piece (10) to a wall section (22) of an appliance and a shield contact element (60, 260) making contact with a cable shield (100) of a cable (36) guided through the cable feedthrough,
**characterized in that** the shield contact element (60, 260) is adapted to be fixed to the fastening section (12) with a holding element (64, 264) and that the shield contact element (60, 260) makes contact with the cable shield (100), on the one hand, and, on the other hand, makes electrical contact with the wall section (22) of the appliance with at least one housing contact element (70, 270) designed to dig into the wall section (22).

2. Cable feedthrough as defined in claim 1, **characterized in that** the at least one housing contact element (70, 270) is designed as a projection (74, 274) provided on the holding element (64, 264).

3. Cable feedthrough as defined in claim 1 or 2, **characterized in that** the projection (74, 274) has a sharp-edged contour (76, 276) facing the wall section (22), the projection (74, 274) being able to dig into a surface of the wall section (22) with said contour.

4. Cable feedthrough as defined in any one of the preceding claims, **characterized in that** the shield contact element (60, 260) is adapted to be fixed to the fastening section (12) in a form locking manner.

5. Cable feedthrough as defined in the preamble to claim 1 or as defined in any one of the preceding claims, **characterized in that** the shield contact element (60, 260) has an annular member (68, 268) engaging around the fastening section (12) of the housing connection piece (10).

6. Cable feedthrough as defined in the preamble to claim 1 or as defined in any one of the preceding claims, **characterized in that** the shield contact element (60, 260) has a sleeve member (66, 266) surrounding the fastening section (12).

7. Cable feedthrough as defined in any one of the preceding claims, **characterized in that** the holding element (64, 264) is adapted to be fixed to the fastening section (12) by a screw connection.

8. Cable feedthrough as defined in any one of claims 1 to 7, **characterized in that** the holding element (64, 264) is adapted to be fixed to the fastening section (12) by means of a form locking element (214) engaging in behind it.

9. Cable feedthrough as defined in any one of the preceding claims, **characterized in that** the shield contact element (60, 260) is adapted to be fixed in place by way of engagement between a supporting element (214) of the fastening section (12) and the wall section (22).

10. Cable feedthrough as defined in any one of the preceding claims, **characterized in that** the housing connection piece (10) is formed from an electrically non-conducting material.

11. Cable feedthrough as defined in any one of the preceding claims, **characterized in that** the shield contact element (60, 260) has a bristle element (102) for making contact with the cable shield (100) and that the bristle element (102), in particular, is designed as a bristle ring having electrically conducting bristles (106) extending transversely in the direction of the central axis (16) of the housing connection piece (10).

12. Cable feedthrough as defined in claim 11, **characterized in that** the bristle element (102) is connected to the holding element (64, 264) of the shield contact element (60, 260).

13. Cable feedthrough as defined in any one of the preceding claims, **characterized in that** the shield contact element (60"', 60"") comprises cable shield contact elements (136, 144).

14. Cable feedthrough as defined in any one of the preceding claims, **characterized in that** the shield contact element (60, 260) has contact bridges (154, 162, 164, 354) for making electrical contact with the cable shield (100).

15. Cable feedthrough as defined in claim 14, **characterized in that** the contact bridges (154, 162, 164, 354) are connected to the holding element (64, 264) and that the contact bridges (154, 162, 164, 354), in particular, comprise clamping arms for making electrical contact with the cable shield (100), said arms being movable radially to the central axis (16) of the housing connection piece (10) in a spring-like manner.

## Revendications

1. Passe-câble comprenant une tubulure de boîtier (10), une fixation de câble (30, 32, 40) prévue sur la tubulure de boîtier, une section de fixation (12) prévue à la tubulure de boîtier (10), avec laquelle la tubulure de boîtier (10) peut être fixée sur une section de paroi (22) d'un appareil, et un élément de contact d'écran (60, 260) établissant un contact avec un écran de câble (100) d'un câble (36) traversant le passe-câble, **caractérisé en ce que** l'élément de contact d'écran (60, 260) peut être fixé avec un élément de retenue (64, 264) sur la section de fixation (12) et **en ce que** l'élément de contact d'écran (60, 260) établit d'une part un contact avec l'écran de câble (100) et établit électriquement d'autre part un contact avec la section de paroi (22) de l'appareil avec au moins un élément de contact de boîtier (70, 270) qui est réalisé s'enfonçant dans la section de paroi (22).

2. Passe-câble selon la revendication 1, **caractérisé en ce que** l'au moins un élément de contact de boîtier (70, 270) est réalisé comme une saillie (74, 274) prévue sur l'élément de retenue (64, 264).

3. Passe-câble selon la revendication 1 ou 2, **caractérisé en ce que** la saillie (74, 274) présente un contour (76, 276) anguleux tourné vers la section de paroi (22), avec lequel la saillie (74, 274) est en mesure de s'enfoncer dans une surface de la section de paroi (22).

4. Passe-câble selon l'une quelconque des revendications précédentes, **caractérisé en ce que** l'élément de contact d'écran (60, 260) peut être fixé à complémentarité de formes sur la section de fixation (12).

5. Passe-câble selon le préambule de la revendication 1 ou selon l'une quelconque des revendications précédentes, **caractérisé en ce que** l'élément de contact d'écran (60, 260) présente un corps annulaire (68, 268) entourant la section de fixation (12) de la tubulure de boîtier (10).

6. Passe-câble selon le préambule de la revendication 1 ou selon l'une quelconque des revendications précédentes, **caractérisé en ce que** l'élément de contact d'écran (60, 260) présente un corps de douille (66, 266) entourant la section de fixation (12).

7. Passe-câble selon l'une quelconque des revendications précédentes, **caractérisé en ce que** l'élément de retenue (64, 264) peut être fixé par un vissage sur la section de fixation (12).

8. Passe-câble selon l'une quelconque des revendications 1 à 7, **caractérisé en ce que** l'élément de retenue (64, 264) peut être fixé en venant en prise derrière un élément à complémentarité de forme (214) sur la section de fixation (12).

9. Passe-câble selon l'une quelconque des revendications précédentes, **caractérisé en ce que** l'élément de contact d'écran (60, 260) peut être fixé par un engagement entre un élément d'appui (214) de la section de fixation (12) et la section de paroi (22).

10. Passe-câble selon l'une quelconque des revendications précédentes, **caractérisé en ce que** la tubulure de boîtier (10) est réalisée en un matériau non électroconducteur.

11. Passe-câble selon l'une quelconque des revendications précédentes, **caractérisé en ce que** l'élément de contact d'écran (60, 260) présente un élément de soie (102) pour le contact de l'écran de câble (100) et **en ce qu'**en particulier l'élément de soie (102) est réalisé comme un anneau de soie qui présente des soies (106) électroconductrices s'étendant transversalement en direction de l'axe médian (16) de la tubulure de boîtier (10).

12. Passe-câble selon la revendication 11, **caractérisé en ce que** l'élément de poil (102) est relié à l'élément de retenue (64, 264) de l'élément de contact d'écran (60, 260).

13. Passe-câble selon l'une quelconque des revendications précédentes, **caractérisé en ce que** l'élément de contact d'écran (60"', 60"" ) comporte des éléments de contact d'écran de câble (136, 144).

14. Passe-câble selon l'une quelconque des revendications précédentes, **caractérisé en ce que** l'élément de contact d'écran (60, 260) présente des étriers de contact (154, 162, 164, 354) pour l'établissement du contact électrique de l'écran de câble (100).

15. Passe-câble selon la revendication 14, **caractérisé en ce que** les étriers de contact (154, 162, 164, 354) sont reliés à l'élément de retenue (64, 264) et **en ce qu'**en particulier les étriers de contact (154, 162, 164, 354) comportent des branches de serrage mobiles élastiquement radialement à l'axe médian (16) de la tubulure de boîtier (10) pour un établissement de contact électrique de l'écran de câble (100).
